# EUROPEAN PATENT APPLICATION

(11) **EP 4 718 725 A1**
(43) Date of publication of application: **01.04.2026**
(21) Application number: 25195316.2
(22) Date of filing: 12.08.2025
(51) Int. Cl.: H03K 17/97, H01H 36/00, H03K 17/95

(54) **LIMIT SWITCH AND ASSOCIATED METHOD**

(30) Priority: 24.09.2024 IN 202411072071
(71) Applicant: Honeywell International Inc., Charlotte, NC 28202 (US)
(72) Inventor: KEZAR, Hussain, Charlotte, 28202 (US); HALL, Jeffrey S., Charlotte, 28202 (US); YAGATI, Veeresh S, Charlotte, 28202 (US); REDDY, K Hari Suriya, Charlotte, 28202 (US); RANJAN, Alok, Charlotte, 28202 (US)
(74) Representative: Haseltine Lake Kempner LLP

(57) **Abstract**

A limit switch is provided. For example, a limit switch may include a housing assembly defining an upper chamber, a lower chamber, and a dividing plate defining a passage between the upper chamber and the lower chamber, a plunger selectively movable relative to the housing assembly, a magnet affixed to a lower portion of the plunger, and a sensor mounted within the lower chamber positioned to interact with the magnet to detect movement of the plunger. A width of the middle portion of the plunger is wider than the passage such that the dividing plate limits movement of the plunger away from its upward-most position. A length of the lower portion of the plunger is selected such that the lower portion of the plunger does not contact a bottom of the lower chamber when the middle portion is in contact with the dividing plate.

## Description

### FIELD OF THE INVENTION

Embodiments of the present disclosure generally relate to switches, and, more particularly, to limit switches.

### BACKGROUND

A limit switch is a device that detects the presence or position of an object by changing the state of electrical contacts when an object touches the switch's actuator. Electromechanical limit switches are currently one of the most widely used type of switch for breaking/making circuits. Electromechanical limit switches are typically based on a snap action switch mechanism.

Some applications in which limit switches are used (e.g., crane outriggers, crane buckets, etc.) need switching combined with high overtravel movement. Overtravel is the plunger travel considered from switching point till the hard stop. Plunger over-travel beyond the hard stop is not possible as it would damage the internal spring. Current electromechanical limit switches do not meet the high overtravel requirement of such applications as they have limited overtravel due to the complex snap action switch mechanism.

Such electromechanical limit switches are plagued by technical challenges and limitations. Through applied effort, ingenuity, and innovation, many of these identified problems have been solved by developing solutions that are included in embodiments of the present disclosure, many examples of which are described in detail herein.

### BRIEF SUMMARY

Various embodiments described herein relate to limit switches devices and associated methods of accommodating overtravel in limit switches.

In accordance with various embodiments of the present disclosure, a limit switch is provided. In some embodiments, the limit switch comprises a housing assembly, a plunger, a magnet, and a sensor. The housing assembly defines an upper chamber having a top opening, a lower chamber, and a dividing plate defining a passage between the upper chamber and the lower chamber. The plunger is partially enclosed and upwardly biased within the housing assembly. The plunger is selectively movable relative to the housing assembly and along a longitudinal axis of the housing assembly. The plunger comprises an upper portion extending at least partially through the top opening of the upper chamber to outside of the housing assembly, a lower portion extending at least partially through the passage into the lower chamber, and a middle portion therebetween. The magnet is affixed to the lower portion of the plunger. The sensor is mounted within the lower chamber positioned to interact with the magnet to detect movement of the plunger. A width of the middle portion of the plunger is wider than the passage such that the dividing plate limits movement of the plunger away from its upward-most position. A length of the lower portion of the plunger is selected such that the lower portion of the plunger does not contact a bottom of the lower chamber when the middle portion is in contact with the dividing plate.

In some embodiments, the magnet is aligned with the sensor when the plunger is biased into its upward-most position.

In some embodiments, the magnet is aligned with the sensor when the plunger is moved away from its upward-most position.

In some embodiments, the sensor comprises an anisotropic magneto resistance sensor.

In some embodiments, the sensor comprises a Hall-effect sensor.

In some embodiments, an upper end of the middle portion of the plunger is in contact with a top surface of the upper chamber when the plunger is biased into its upward-most position.

In some embodiments, the limit switch further comprises a biasing spring to upwardly bias the plunger within the housing assembly.

In some embodiments, the limit switch further comprises a seal positioned to seal the top opening of the upper chamber against the upper portion of the plunger extending at least partially through the top opening of the upper chamber.

In some embodiments, the limit switch further comprises a printed circuit board mounted within the lower chamber and the sensor is mounted on the printed circuit board.

In some embodiments, the lower portion of the plunger and the passage defined in the dividing plate have complementary shapes to ensure a fixed alignment between the lower portion of the plunger and the passage defined in the dividing plate which, in turn, ensures a fixed alignment between the magnet and the sensor.

In some embodiments, the housing assembly comprises an upper body at least partially defining the upper chamber and a lower body at least partially defining the lower chamber, and the upper body and the lower body have complementary shapes to ensure a fixed alignment between the upper body and the lower body which, in turn, ensures a fixed alignment between the magnet and the sensor.

In accordance with various embodiments of the present disclosure, a method of accommodating overtravel in a limit switch is provided. In some embodiments, the method comprises positioning a plunger at least partially within a housing assembly, the housing assembly defining an upper chamber having a top opening, a lower chamber, and a dividing plate defining a passage between the upper chamber and the lower chamber, the plunger selectively movable relative to and along a longitudinal axis of the housing assembly, the plunger comprising an upper portion extending at least partially through the top opening of the upper chamber to outside of the housing assembly, a lower portion extending at least partially through the passage into the lower chamber, and a middle portion therebetween; upwardly biasing the plunger within the housing assembly, affixing a magnet to the lower portion of the plunger; and mounting a sensor within the lower chamber positioned to interact with the magnet to detect movement of the plunger. A width of the middle portion of the plunger is wider than the passage such that the dividing plate limits movement of the plunger away from its upward-most position, and a length of the lower portion of the plunger is selected such that the lower portion of the plunger does not contact a bottom of the lower chamber when the middle portion is in contact with the dividing plate.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a perspective view of an example limit switch in accordance with example embodiments of the present disclosure;
FIG. 2 is a sectional view of the example limit switch of FIG. 1 in a first state;
FIG. 3 is a sectional view of the example limit switch of FIG. 1 in a second state;
FIG. 4 is a partial exploded perspective view of the example limit switch of FIG. 1;
FIG. 5 is a perspective view of a portion of the example limit switch of FIG. 1; and
FIG. 6 is a block diagram of example switching circuitry of an example limit switch in accordance with example embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," "in some examples," and the like generally mean that the particular feature, structure, or characteristic following the phrase may be included in at least one example of the present disclosure and may be included in more than one example of the present disclosure (importantly, such phrases do not necessarily refer to the same example).

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

The term "electronically coupled," "electronically coupling," "electronically couple," "in communication with," "in electronic communication with," or "connected" in the present disclosure refers to two or more elements or components being connected through wired means and/or wireless means, such that signals, electrical voltage/current, data and/or information may be transmitted to and/or received from these elements or components.

The term "component" may refer to an article, a device, or an apparatus that may comprise one or more surfaces, portions, layers and/or elements. For example, an example component may comprise one or more substrates that may provide underlying layer(s) for the component and may comprise one or more elements that may form part of and/or are disposed on top of the substrate. In the present disclosure, the term "element" may refer to an article, a device, or an apparatus that may provide one or more functionalities.

The term "limit switch" may refer to a device that detects the presence or position of an object by changing its electrical state when an object touches the switch's actuator.

Various embodiments of the present disclosure overcome the technical difficulties and challenges and provide various technical improvements to such limit switches. Embodiments of the present disclosure provide a limit switch and a method for accommodating overtravel in a limit switch. In accordance with various embodiments of the present disclosure, a limit switch is provided that combines mechanical actuation with electronic switching and an improved overtravel mechanism. Various embodiments of the present disclosure improve reliability and improve overtravel performance by eliminating the snap-action / contact block switching mechanism of conventional electromechanical limit switches, which eliminates wear and tear and arcing issues. Various embodiments of the present disclosure reduce the risk of overtravel damage with a unique actuator (termed a plunger) design providing a fail-safe mechanical stopper mechanism.

Various embodiments of the present disclosure provide a rugged, sealed design to operate in harsh/hazardous environments. Various embodiments of the present disclosure provide alignment features to ensure the correct alignment between the magnet and the sensor required for electronic switching. Various embodiments of the present disclosure enable a higher switching frequency, lower response times, and higher lifecycles as compared to conventional electromechanical limit switches. Various embodiments of the present disclosure can be integrated with advances features, such as data collection, Internet-of-Things (IoT) applications, and remote operation capabilities.

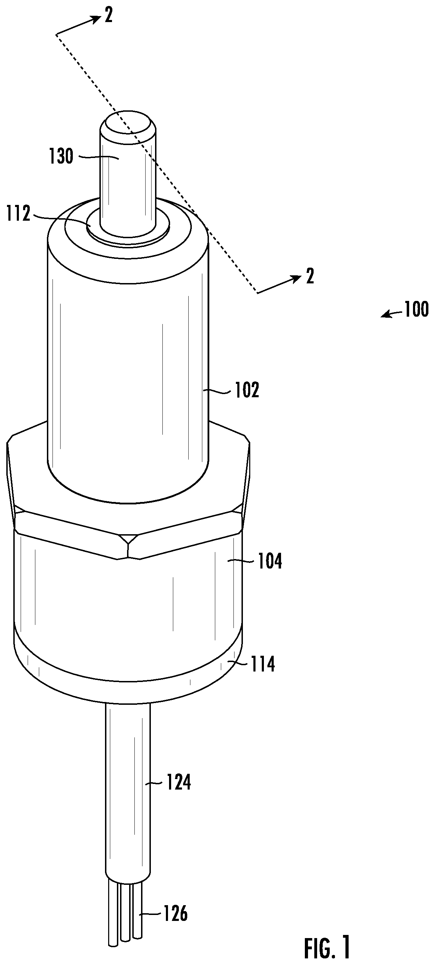

Referring now to FIGS. 1-5, an example limit switch 100 in accordance with various embodiments of the present disclosure is provided. As illustrated, the limit switch 100 comprises a housing assembly 102 and a plunger 130 (i.e., actuator) protruding from a top opening 108 in an upper end of the housing assembly 102. In operation, the limit switch 100 is mounted in a position such that an object whose position is to be detected would contact and depress the plunger 130, thereby actuating the limit switch 100. Various features of the limit switch of embodiments of the present disclosure, described below, reduce the likelihood of damage to the limit switch when the object whose position is to be detected moves closer to the limit switch than expected (i.e., when overtravel occurs).

In the illustrated example, the housing assembly 102 of the limit switch 100 is constructed as a two-piece assembly comprising an upper body 104 and a lower body 114. In various embodiments, the upper body 104 and the lower body 114 may be joined using any suitable mechanism or method, such as welding, an adhesive. In various embodiments, the upper body 104, the lower body 114, and the plunger 130 may be constructed of any suitable material, such as but not limited to metal or any suitable plastic.

In various embodiments, the housing assembly 102 defines an upper chamber 106 and a lower chamber 116. A dividing wall or plate 120 separates the upper chamber 106 from the lower chamber 116. A passage 122 is defined in the dividing plate 120.

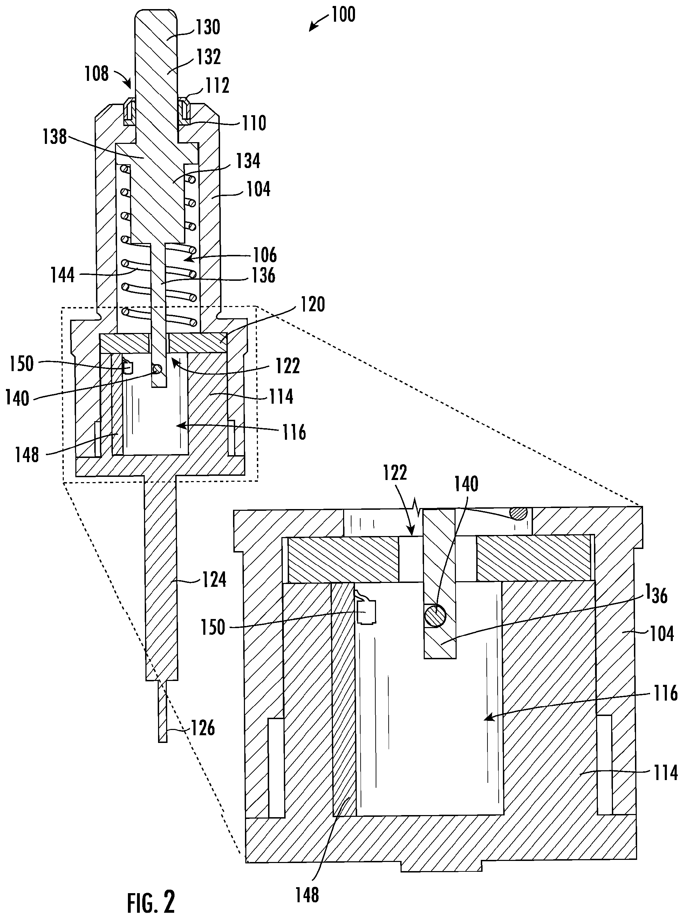

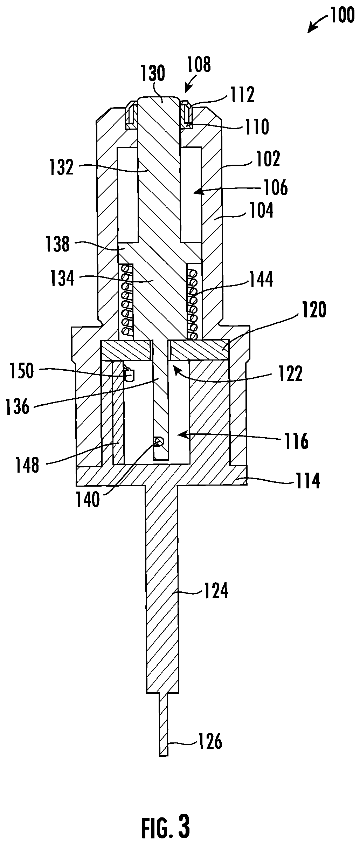

The plunger 130 is selectively movable within and relative to the housing assembly 102, along a longitudinal axis of the housing assembly 102, between a first state (which may also be termed a free state or an unactuated state) (shown in FIG. 2) and a second state (which may also be termed a depressed state or an actuated state) (shown in FIG. 3). In the illustrated embodiment, the plunger 130 comprises an upper portion 132 (part of which extends outside of the housing assembly 102 through top opening 108), a middle portion 134, and a lower portion 136 (part of which extends through the passage 122 into the lower chamber 116). In the illustrated embodiment, the plunger 130 further comprises a circumferential collar 138 extending outward from the longitudinal axis of the plunger between the upper portion 132 and the middle portion 134.

In the illustrated embodiment, a seal 110 (protected by a guard 112) is positioned to seal the top opening 108 against the upper portion 132 of the plunger 130 to help prevent contaminants from entering the limit switch.

In the illustrated embodiment, the plunger 130 is biased upward (i.e., toward the top opening 108) by biasing spring 144 whose bottom end pushes against the dividing plate 120 and whose top end pushes against the collar 138 of the plunger 130. In the upward-most position (shown in FIG. 3), the collar 138 of the plunger 130 contacts the top end of the upper chamber 106 to limit the upward movement of the plunger 130.

In the illustrated embodiment, when the plunger 130 is pushed far down (such as in an overtravel situation), the bottom end of the middle portion 134 of the plunger 130 (which has a greater diameter than that of the lower portion 136) contacts the dividing plate 120 to limit the downward movement of the plunger 130. Notably, when the plunger is in this downward-most position, the bottom end of the lower portion 136 of the plunger 130 does not contact the floor of the lower chamber 116, thereby avoiding possible damage to the plunger 130 or the lower body 114.

In various embodiments, a magnet 140 is affixed to the lower portion 136 of the plunger 130. In various embodiments, the magnet 140 may comprise any suitable type of magnet (e.g., a rare earth magnet) and have any suitable shape (e.g., cylinder or rectangular prism). In various embodiments, the magnet 140 may be affixed to the lower portion 136 of the plunger 130 using any suitable mechanism or method, such as an adhesive and/or by embedding the magnet in a cavity created in the lower portion 136 of the plunger 130.

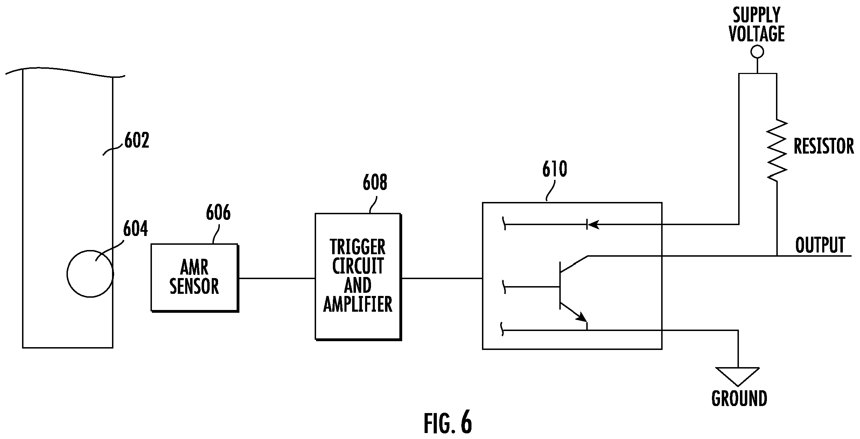

In various embodiments, the limit switch 100 comprises a sensor 150 mounted within the lower chamber 116. In various embodiments, the sensor comprises any suitable type of sensor, such as Hall-effect sensors which respond to magnetic fields perpendicular to the sensor or anisotropic magneto resistance (AMR) sensors which respond to magnetic fields parallel to the sensor and react to both magnetic poles. In the illustrated embodiment, the sensor 150 is mounted on a printed circuit board (PCB) 148 that is also mounted within the lower chamber 116. In various embodiments, various other circuitry may be mounted on the PCB 148, such as the switching circuitry described further below in relation to FIG. 6. In various embodiments in which the sensor is an AMR sensor, the magnet 140 is affixed to the lower portion 136 of the plunger 130 in a position such that the longitudinal axis of the magnet 140 is parallel to the sensor.

As seen in FIGS. 2 and 3, because the magnet 140 is affixed to the lower portion 136 of the plunger 130, the magnet 140 moves up and down with movement of the plunger 130. In various embodiments, the sensor 150 is positioned to interact with the magnet 140 to detect movement of the plunger 130. In the illustrated embodiment, the magnet 140 is aligned with the sensor 150 when the plunger 130 is biased into its upward-most position, as seen in FIG. 2 and magnet 140 becomes unaligned with the sensor 150 when the plunger 130 moves downward from its upward-most position, as seen in FIG. 3. As such, the sensor 150 detects the magnet 140 when the plunger 130 is biased into its upward-most position and the sensor 150 does not detect the magnet 140 when the plunger 130 moves downward from its upward-most position. In this regard, the sensor 150 can detect movement of the magnet 140 and therefore movement of the plunger 130 and actuation of the limit switch 100.

In the illustrated embodiment, the limit switch 100 comprises a termination cable 124 through which wire leads 126 run from the switching circuitry to various control circuitry or the like (e.g., a programmable logic controller) to receive and process an actuation signal from the limit switch 100.

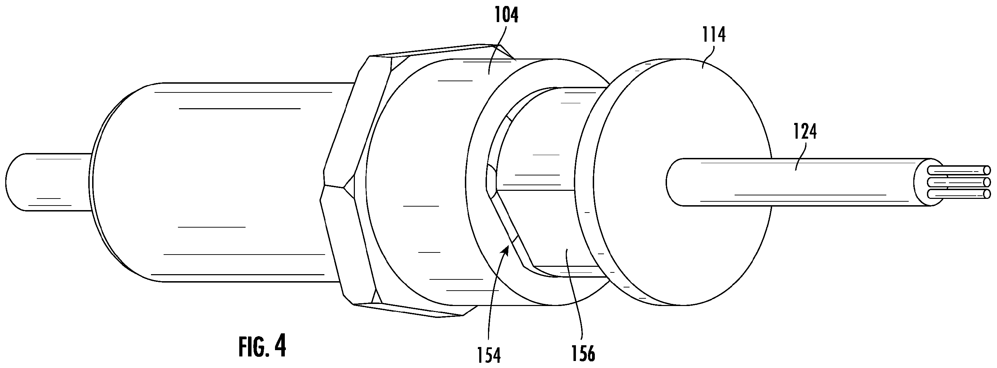

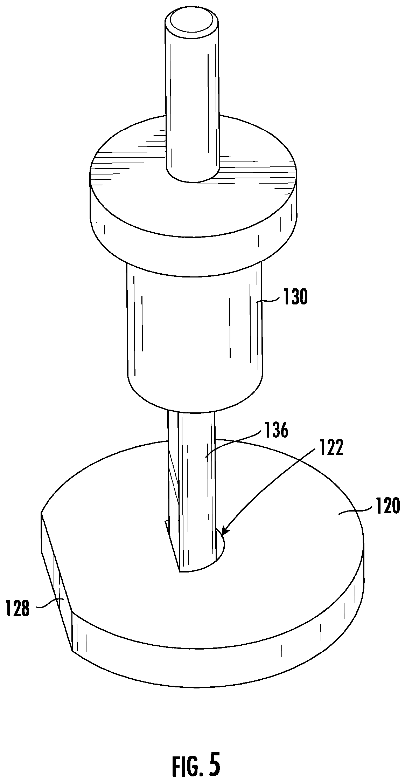

In various embodiments, as seen in FIG. 4, during assembly of the limit switch 100 the lower body 114 is inserted into an open bottom end of the upper body 104. In various embodiments, the upper body and the lower body have complementary shapes to ensure a fixed alignment between the upper body and the lower body which, in turn, ensures a fixed alignment between the magnet and the sensor. In the illustrated embodiment, these complementary shapes are provided by a flattened outer wall portion 156 (of an otherwise cylindrical portion) of the lower body 114 which corresponds to a flattened inner wall portion 154 (of an otherwise cylindrical portion) of the upper body 104. When the lower body 114 is fully inserted into the upper body 104, the mating flattened wall portions 154, 156 prevent twisting motion of the lower body 114 and the upper body 104 relative to each other. As seen in FIG. 5, the dividing plate 120 has a similar flattened outer wall portion 128 (of an otherwise cylindrical shape) that prevents a twisting motion of the dividing plate 120 relative to the lower body 114 and the upper body 104.

As described above, the lower portion of the plunger protrudes through the passage defined in the dividing plate. In some embodiments, the lower portion of the plunger and the passage defined in the dividing plate have complementary shapes to ensure a fixed alignment between the lower portion of the plunger and the passage defined in the dividing plate which, in turn, ensures a fixed alignment between the magnet and the sensor. In the illustrated embodiment of FIG. 5, these complementary shapes are provided by the passage 122 having a 'D' shape and the lower portion 136 of the plunger 130 having a similar 'D' shaped cross-section. When the lower portion 136 of the plunger 130 is protruding through the passage 122 of the dividing plate 120, the mating 'D' shapes prevent twisting motion of the plunger 130 and the dividing plate 120 relative to each other. Because the flattened outer wall portion 128 of the dividing plate 120 prevents twisting motion of the dividing plate 120 relative to the lower body 114 (in which the sensor 150 is housed), the mating 'D' shapes of the lower portion 136 of the plunger and the passage 122 of the dividing plate 120 therefore also prevent twisting motion of the lower portion 136 of the plunger 130 and the magnet 140 mounted thereto relative to the sensor 150.

FIG. 6 is a block diagram of example circuitry of an example limit switch in accordance with example embodiments of the present disclosure. In various embodiments, such circuitry may be mounted on the PCB 148 of the limit switch 100 of FIGS. 1-5. FIG. 6 illustrates a lower portion 602 of a plunger and a magnet 604 mounted thereto, with a sensor 606 aligned with the magnet 604. In the embodiment illustrated in FIG. 6, the circuitry comprises a trigger circuit and amplifier circuit 608 and switching circuitry 610. In the illustrated embodiment, the switching circuitry 610 comprises a diode connected to a supply voltage (the same supply voltage is fed to the trigger circuit and amplifier circuit 608 and the sensor 606), and a transistor whose base is connected to the trigger circuit and amplifier circuit 608, whose emitter is connected to ground, and whose collector is connected to a resistor tied to the supply voltage and provides the output of the limit switch.

In operation, when the plunger is depressed in vertical direction, the magnet 604 moves out of sensing range of the sensor 606, generating an enable signal. This signal is then strengthened by the trigger circuit and amplifier 608, leading to the deactivation of the transistor of the switching circuitry 610. Consequently, the output signal transitions from a high to a low state.

While various embodiments in accordance with the principles disclosed herein have been shown and described above, modifications thereof may be made by one skilled in the art without departing from the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above, but is defined by the claims which follow, that scope including all equivalents of the subject matter of the claims. Each and every claim is incorporated as further disclosure into the specification and the claims are embodiment(s) of the present disclosure. Furthermore, any advantages and features described above may relate to specific embodiments but shall not limit the application of such issued claims to processes and structures accomplishing any or all of the above advantages or having any or all of the above features.

In addition, the section headings used herein are provided for consistency with the suggestions under 37 C.F.R. § 1.77 or to otherwise provide organizational cues. These headings shall not limit or characterize the disclosure set out in any claims that may issue from this disclosure. For instance, a description of a technology in the "Background" is not to be construed as an admission that certain technology is prior art to any disclosure in this disclosure. Neither is the "Summary" to be considered as a limiting characterization of the disclosure set forth in issued claims. Furthermore, any reference in this disclosure to "disclosure" or "embodiment" in the singular should not be used to argue that there is only a single point of novelty in this disclosure. Multiple embodiments of the present disclosure may be set forth according to the limitations of the multiple claims issuing from this disclosure, and such claims accordingly define the disclosure, and their equivalents, which are protected thereby. In all instances, the scope of the claims shall be considered on their own merits in light of this disclosure but should not be constrained by the headings set forth herein.

Also, systems, subsystems, apparatuses, techniques, and methods described and illustrated in the various embodiments as discrete or separate may be combined or integrated with other systems, modules, techniques, or methods without departing from the scope of the present disclosure. Other devices or components shown or discussed as coupled to, or in communication with, each other may be indirectly coupled through some intermediate device or component, whether electrically, mechanically, or otherwise. Other examples of changes, substitutions, and alterations are ascertainable by one skilled in the art and could be made without departing from the scope disclosed herein.

Many modifications and other embodiments of the disclosure set forth herein will come to mind to one skilled in the art to which these embodiments pertain having the benefit of teachings presented in the foregoing descriptions and the associated figures. Although the figures only show certain components of the apparatuses and systems described herein, various other components may be used in conjunction with the components and structures disclosed herein. Therefore, it is to be understood that the disclosure is not to be limited to the specific embodiments disclosed and that modifications and other embodiments are intended to be included within the scope of the appended claims. For example, the various elements or components may be combined, rearranged, or integrated in another system or certain features may be omitted or not implemented. Moreover, the steps in any method described above may not necessarily occur in the order depicted in the accompanying drawings, and in some cases one or more of the steps depicted may occur substantially simultaneously, or additional steps may be involved. Although specific terms are employed herein, they are used in a generic and descriptive sense only and not for purposes of limitation.

## Claims

1. A limit switch comprising:
a housing assembly defining an upper chamber having a top opening, a lower chamber, and a dividing plate defining a passage between the upper chamber and the lower chamber;
a plunger partially enclosed and upwardly biased within the housing assembly, the plunger selectively movable relative to the housing assembly and along a longitudinal axis of the housing assembly, the plunger comprising an upper portion extending at least partially through the top opening of the upper chamber to outside of the housing assembly, a lower portion extending at least partially through the passage into the lower chamber, and a middle portion therebetween;
a magnet affixed to the lower portion of the plunger; and
a sensor mounted within the lower chamber positioned to interact with the magnet to detect movement of the plunger;
wherein a width of the middle portion of the plunger is wider than the passage such that the dividing plate limits movement of the plunger away from its upward-most position; and
wherein a length of the lower portion of the plunger is selected such that the lower portion of the plunger does not contact a bottom of the lower chamber when the middle portion is in contact with the dividing plate.

2. The limit switch of claim 1, wherein the magnet is aligned with the sensor when the plunger is biased into its upward-most position.

3. The limit switch of claim **1,** wherein the sensor comprises an anisotropic magneto resistance sensor or a Hall-effect sensor.

4. The limit switch of claim **1,** wherein an upper end of the middle portion of the plunger is in contact with a top surface of the upper chamber when the plunger is biased into its upward-most position.

5. The limit switch of claim **1,** further comprising a biasing spring to upwardly bias the plunger within the housing assembly.

6. The limit switch of claim 1, further comprising a seal positioned to seal the top opening of the upper chamber against the upper portion of the plunger extending at least partially through the top opening of the upper chamber.

7. The limit switch of claim **1,** further comprising a printed circuit board mounted within the lower chamber;
wherein the sensor is mounted on the printed circuit board.

8. The limit switch of claim **1,** wherein the lower portion of the plunger and the passage defined in the dividing plate have complementary shapes to ensure a fixed alignment between the lower portion of the plunger and the passage defined in the dividing plate which, in turn, ensures a fixed alignment between the magnet and the sensor.

9. The limit switch of claim 1, wherein the housing assembly comprises an upper body at least partially defining the upper chamber and a lower body at least partially defining the lower chamber; and
wherein the upper body and the lower body have complementary shapes to ensure a fixed alignment between the upper body and the lower body which, in turn, ensures a fixed alignment between the magnet and the sensor.

10. A method of accommodating overtravel in a limit switch, the method comprising:
positioning a plunger at least partially within a housing assembly, the housing assembly defining an upper chamber having a top opening, a lower chamber, and a dividing plate defining a passage between the upper chamber and the lower chamber, the plunger selectively movable relative to the housing assembly and along a longitudinal axis of the housing assembly, the plunger comprising an upper portion extending at least partially through the top opening of the upper chamber to outside of the housing assembly, a lower portion extending at least partially through the passage into the lower chamber, and a middle portion therebetween;
upwardly biasing the plunger within the housing assembly,
affixing a magnet to the lower portion of the plunger; and
mounting a sensor within the lower chamber positioned to interact with the magnet to detect movement of the plunger;
wherein a width of the middle portion of the plunger is wider than the passage such that the dividing plate limits movement of the plunger away from its upward-most position; and
wherein a length of the lower portion of the plunger is selected such that the lower portion of the plunger does not contact a bottom of the lower chamber when the middle portion is in contact with the dividing plate.

11. The method of claim 10, wherein the magnet is aligned with the sensor when the plunger is biased into its upward-most position.

12. The method of claim 10, wherein an upper end of the middle portion of the plunger is in contact with a top surface of the upper chamber when the plunger is biased into its upward-most position.

13. The method of claim 10, further comprising positioning a seal to seal the top opening of the upper chamber against the upper portion of the plunger extending at least partially through the top opening of the upper chamber.

14. The method of claim 10, wherein the lower portion of the plunger and the passage defined in the dividing plate have complementary shapes to ensure a fixed alignment between the lower portion of the plunger and the passage defined in the dividing plate which, in turn, ensures a fixed alignment between the magnet and the sensor.

15. The method of claim 10, wherein the housing assembly comprises an upper body at least partially defining the upper chamber and a lower body at least partially defining the lower chamber; and
wherein the upper body and the lower body have complementary shapes to ensure a fixed alignment between the upper body and the lower body which, in turn, ensures a fixed alignment between the magnet and the sensor.
